# EUROPEAN PATENT APPLICATION

(11) **EP 2 282 619 A1**
(43) Date of publication of application: **09.02.2011**
(21) Application number: 09750500.2
(22) Date of filing: 14.05.2009
(51) Int. Cl.: H05H 1/46, C23C 16/509, H01L 21/205, H01L 21/3065

(54) **PLASMA PROCESSING APPARATUS**

(30) Priority: 21.05.2008 JP 2008133073
(71) Applicant: Sharp Kabushiki Kaisha, Osaka-shi, Osaka 545-8522 (JP)
(72) Inventor: KISHIMOTO, Katsushi, Osaka 545-8522 (JP); FUKUOKA, Yusuke, Osaka 545-8522 (JP)
(74) Representative: Müller, Achim Fritz
(86) International application number: PCT/JP2009/058995
(87) International publication number: WO 2009/142138

(57) **Abstract**

A plasma processing apparatus, comprising:
a reaction chamber;
a gas inlet portion that introduces a reactant gas into the reaction chamber;
an exhaust portion that exhausts the reactant gas from said reaction chamber;
at least three discharge portions respectively made up of first electrode and second electrode pairs, a first electrode and a second electrode constituting each one of the first electrode and second electrode pairs being disposed to oppose to each other inside said reaction chamber, so as to cause a plasma discharge in the reactant gas;
a support portion that supports and parallels the first electrode and second electrode pairs in one of a horizontal manner and a vertical manner; and
a power supply portion that supplies power to all of said discharge portions, wherein
said power supply portion includes a high frequency generator and an amplifier that amplifies high frequency power from the high frequency generator to be supplied to the first electrodes, and
a first electrode of one discharge portion out of said discharge portions and a first electrode of other discharge portion out of said discharge portions being adjacent to the one discharge portion are connected to an identical one of the high frequency generator respectively via separate ones of the amplifier, or respectively connected to separate ones of the high frequency generator via the amplifier, and the second electrodes of respective discharge portions are grounded.

## Description

### TECHNICAL FIELD

The present invention relates to a plasma processing apparatus. More specifically, the present invention relates to a structure of a plasma processing apparatus in which a plurality of cathode and anode electrode pairs that each cause a plasma discharge are disposed in a chamber.

### BACKGROUND ART

An exemplary conventional plasma processing apparatus including therein a chamber in which a plurality of cathode and anode electrode pairs each causing a plasma discharge are disposed in a vertical order may be a plasma processing apparatus disclosed in Patent Document 1.
Of the plurality of the electrodes disposed in the vertical order in the plasma processing apparatus, a topmost electrode and the electrodes except for every second electrode with reference to the topmost electrode are cathode electrodes that are electrically connected to a high frequency power supply, and the remains of the electrodes are grounded anode electrodes.
The plasma processing apparatus further includes a heater in every electrode except for the topmost electrode. Into every electrode except for a bottommost electrode, a reactant gas is supplied, which is sprayed from a multitude of gas spray holes formed at a bottom surface.

With the plasma processing apparatus disclosed in Patent Document 1 being structured in this manner, a substrate is placed on every electrode pair except for the topmost electrode. By a plasma discharge occurring at each interelectrode having the reactant gas, a film deposition or an etching process takes place on a surface of each substrate. This plasma processing apparatus has the following disadvantages.
(1) The substrates are placed without distinguishing between the cathode electrodes and the anode electrodes, and the plasma discharge occurs between every adjacent ones of the electrodes. Therefore, as to the film deposition, both a film formed on the substrate on each cathode electrode and a film formed on the substrate on each anode electrode exist in a mixed up manner. On the other hand, as to the etching, both a substrate having undergone the etching on each cathode electrode and a substrate having undergone the etching on each anode electrode exist in a mixed up manner. Such events are not preferable, because they result in use of poor quality films formed on the substrates on the cathode electrodes and a process onto the substrates on the anode electrodes unsuited for etching.
(2) While the occurrence of the plasma discharges is inevitable because a distance between every adjacent ones of the electrodes is constant, it is still possible not to perform the deposition process to the substrate on each cathode electrode unsuited for the deposition, and not to perform the etching process to the substrate on each anode electrode unsuited for etching. Nevertheless, adjacent ones of plasmas interfere with each other because the plasma discharges themselves cannot be suppressed. This makes the discharge extremely unstable.

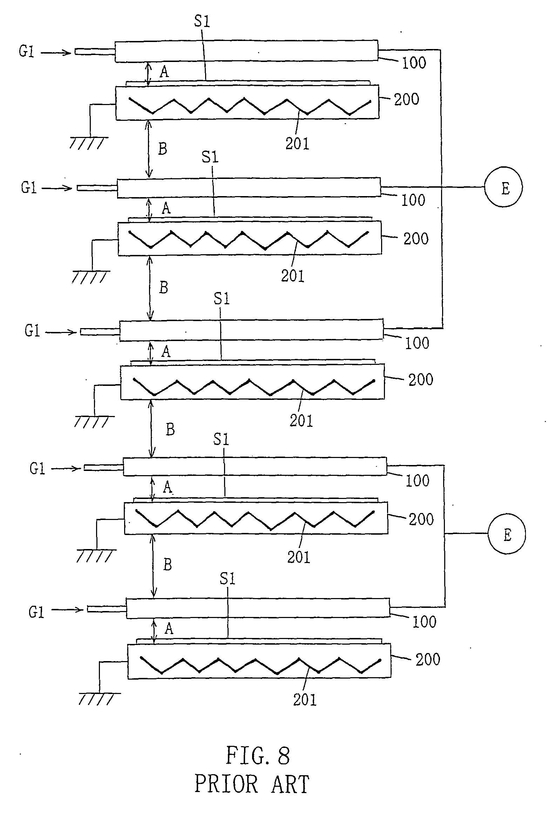

As a plasma processing apparatus for overcoming such disadvantages, an apparatus structured as shown in Fig. 8 has been proposed (see Patent Document 2).
In the plasma processing apparatus, for example, a plurality of discharge portions each made up of a cathode electrode 100 connected to a power supply portion E and an anode electrode 200 grounded are disposed in the vertical order in a chamber. Each anode electrode 200 on a bottom side includes a heater 201 therein, and on a top surface of the anode electrode 200, a substrate S1 is placed. On the other hand, a reactant gas G1 is introduced inside each cathode electrode 100 as shown by each arrow, which is sprayed from a multitude of holes formed at a bottom surface of each cathode electrode 100. Then, a plasma discharge occurs between each ones of the cathode and anode electrodes under a reactant gas atmosphere, whereby a film is formed on a surface of each substrate S 1.
Further, this plasma processing apparatus is structured to function as an etching apparatus, by having each cathode electrode shown in Fig. 8 arranged beneath each anode electrode, with a substrate placed on the cathode electrode. In this case, the reactant gas is introduced inside each grounded anode electrode, and sprayed between each ones of cathode and anode electrodes from the multitude of holes formed at the bottom surface of each grounded anode electrode. The heater is provided inside each cathode electrode connected to the power supply.

Further, in the plasma apparatus disclosed in Patent Document 2, the power supply portion E that supplies power to a plurality of the cathode electrodes 100 is shared by them, irrespective of whether the plasma apparatus is structured as a deposition apparatus or the etching apparatus. Therefore, for example, to the cathode electrodes 100 of prescribed plural numbers (three in Fig. 8) of discharge portions adjacent to one another, a power supply portion E is connected via an identical electrical system, and to the cathode electrodes 100 of the prescribed plural numbers (two in Fig. 8) of other discharge portions adjacent to one another, the power supply portion E is connected via another electrical system being different from the electrical system.
Still further, an inter-discharge portion distance B between the anode electrode 200 of one discharge portion and the cathode electrode 100 of other discharge portion adjacent to the one discharge portion is set to be at least twice as great as an interelectrode distance A between each cathode electrode 100 and each anode electrode 200.

This is described in more detail. In the plasma processing apparatus shown in Fig. 8, each power supply portion E includes a high frequency generator and an amplifier that amplifies high frequency power from the high frequency generator to supply the cathode electrodes 100.
The three cathode electrodes 100 belonging to a top discharge portion group are connected to the identical high frequency generator respectively via separate amplifiers (see Fig. 8), or to different high frequency generators via amplifiers, respectively (not shown). Further, the inter-discharge portion distance B is set to be at least twice as great as the interelectrode distance A. The same holds true for two discharge portions belonging to a bottom discharge portion group.
In the plasma processing apparatus structured as above, the power is equally distributed in each discharge portion group, so as to be supplied to a plurality of the cathode electrodes 100. As a result, even if the plasma discharges are caused by a plurality of the discharge portions in the chamber, interference among them can be prevented, and the deposition or the etching can uniformly be performed.

### PRIOR ART DOCUMENTS

### PATENT DOCUMENTS

Patent Document 1: US Patent No. 4,264,393
Patent Document 2: Japanese Patent Laid-open Publication No. 2006-120926

### DISCLOSURE OF THE INVENTION

### PROBLEMS TO BE SOLVED BY THE INVENTION

However, with the deposition purpose plasma processing apparatus as shown in Fig. 8, when the inter-discharge portion distance B is narrowed to be less than twice as great as the interelectrode distance A, the plasma discharges at two adjacent discharge portions interfere with each other, whereby the power cannot be equally distributed. As a result, it becomes impossible to carry out uniform plasma processing over the entire apparatus, and hence, an increase in a filling rate of the discharge portions inside the chamber cannot be achieved, or a reduction in size of the entire apparatus cannot be achieved.

The present invention has been made in consideration of the foregoing problems, and an object of the present invention is to provide a plasma processing apparatus that can realize an increase in the filling rate of the discharge portions inside the chamber, while realizing the uniform plasma processing over the entire apparatus.

Therefore, the present invention provides a plasma processing apparatus including a reaction chamber, a gas inlet portion that introduces a reactant gas into the reaction chamber, an exhaust portion that exhausts the reactant gas from said reaction chamber, at least three discharge portions respectively made up of first electrode and second electrode pairs, a first electrode and a second electrode constituting each one of the first electrode and second electrode pairs being disposed to oppose to each other inside said reaction chamber, so as to cause a plasma discharge in the reactant gas, a support portion that supports and parallels the first electrode and second electrode pairs in one of a horizontal manner and a vertical manner, and a power supply portion that supplies power to all of said discharge portions, wherein
said power supply portion includes a high frequency generator and an amplifier that amplifies high frequency power from the high frequency generator to be supplied to the first electrodes, and
a first electrode of one discharge portion out of said discharge portions and a first electrode of other discharge portion out of said discharge portions being adjacent to the one discharge portion are connected to an identical one of the high frequency generator respectively via separate ones of the amplifier, or respectively connected to separate ones of the high frequency generator via the amplifier, and the second electrodes of respective discharge portions are grounded.

### EFFECT OF THE INVENTION

With the plasma processing apparatus of the present invention, a first electrode of one discharge portion out of all discharge portions and a first electrode of other discharge portion adjacent to the one discharge portion are connected to an identical high frequency generator via separate amplifiers, or connected to different high frequency generators via an amplifier. Thus, the first electrodes of the adjacent discharge portions are connected to a power supply portion respectively via different electrical systems. As a result, plasma discharges occurring at the two adjacent discharge portions are less prone to interfere with each other as compared with the conventional plasma processing apparatus shown in Fig. 8, and it becomes possible to narrow the inter-discharge portion distance B as compared with the conventional one. Further, each discharge portion connected to the power supply portion via the same electrical system is equally supplied with power. Thus, equal plasma processing is carried out at each discharge portion.

### BRIEF DESCRIPTION OF THE DRAWINGS

Fig. 1 is a schematic configuration diagram showing a first embodiment of a plasma processing apparatus of the present invention.
Fig. 2 is an explanatory diagram showing a first power supply connection mode according to the first embodiment of the present invention.
Fig. 3 is an explanatory diagram showing a second power supply connection mode according to the first embodiment of the present invention.
Fig. 4 is an explanatory diagram showing a power supply position in each first electrode according to the first embodiment of the present invention.
Fig. 5 is a schematic configuration diagram showing a second embodiment of the plasma processing apparatus of the present invention.
Fig. 6 is a schematic configuration diagram showing a third embodiment of the plasma processing apparatus of the present invention.
Fig. 7 is a schematic configuration diagram showing a fourth embodiment of the plasma processing apparatus of the present invention.
Fig. 8 is a schematic configuration diagram showing a conventional deposition purpose plasma processing apparatus.

### MODE FOR CARRYING OUT THE INVENTION

A plasma processing apparatus of the present invention includes:
a reaction chamber;
a gas inlet portion that introduces a reactant gas into the reaction chamber;
an exhaust portion that exhausts the reactant gas from the reaction chamber;
at least three discharge portions respectively made up of first electrode and second electrode pairs, a first electrode and a second electrode constituting each one of the first electrode and second electrode pairs being disposed to oppose to each other inside the reaction chamber, so as to cause a plasma discharge in the reactant gas;
a support portion that supports and parallels the first electrode and second electrode pairs in one of a horizontal manner and a vertical manner; and
a power supply portion that supplies power to all of the discharge portions, wherein
the power supply portion includes a high frequency generator and an amplifier that amplifies high frequency power from the high frequency generator to be supplied to the first electrodes, and
a first electrode of one discharge portion out of the discharge portions and a first electrode of other discharge portion out of the discharge portions being adjacent to the one discharge portion are connected to an identical one of the high frequency generator respectively via separate ones of the amplifier, or respectively connected to separate ones of the high frequency generator via the amplifier, and the second electrodes of respective discharge portions are grounded.

Here, to support and parallel the first electrode and second electrode pairs in a horizontal manner means that the electrodes of a parallel plate type are aligned in a top-bottom direction as being laid in a horizontal manner, and to support and parallel the first electrode and second electrode pairs in a vertical manner means that the electrodes of the parallel plate type are aligned in a sideways direction as standing upright in a vertical manner. In other words, the present plasma processing apparatus is a plasma processing apparatus that can be applied to both a top-bottom parallel type in which a plurality of parallel plate type discharge portions (electrode pairs) each made up of a first electrode and a second electrode are aligned in the top-bottom direction, and to a sideways parallel type in which a plurality of parallel plate type discharge portions are aligned in the sideways direction.
Further, in the present invention, positions of each first electrode and each second electrode relative to each other are not limited. That is, in the present invention, a substrate being a processing target object that undergoes the plasma processing may be positioned on either side of the first electrode or the second electrode. In a case where the substrate is placed on the second electrode, the present invention implements a structure of a deposition purpose plasma processing apparatus. When the substrate is placed on the first electrode, the present invention implements a structure of an etching purpose plasma processing apparatus.

In the plasma processing apparatus, the first electrode of one discharge portion out of all the discharge portions and the first electrode of other discharge portion adjacent to the one discharge portion are, as described above, connected in one of the following modes: (a) they are connected to an identical high frequency generator via separate amplifiers; and (b) they are connected to separate high frequency generators via an amplifier.
Here, the connection modes (a) and (b) between the first electrodes and the power supply portion mean that the first electrode of the one discharge portion and the first electrode of the other discharge portion adjacent to the one discharge portion are connected to the power supply portion respectively via different electrical systems.
With the plasma processing apparatus of the present invention, by adopting one of the connection modes (a) and (b) between the first electrodes and the power supply portion, the first electrodes of two adjacent discharge portions are connected to the power supply portion respectively via different electrical systems. Therefore, plasma discharges at the two adjacent discharge portions are less prone to interfere with each other as compared with the conventional plasma processing apparatus shown in Fig. 8, and it becomes possible to set the inter-discharge portion distance B narrower than that in the conventional one.

Specifically, when there exist a plurality of discharge portions in the reaction chamber, a cause of the plasma discharge interference among the discharge portions is particularly related to the inter-discharge portion distance between the discharge portions that are connected to the power supply portion via an identical electrical system. When the inter-discharge portion distance between the discharge portions is shortened, the power cannot equally be distributed and, as a result, the plasma discharges interfere with each other.
In the present invention, the discharge portions connected to the power supply portion via the identical electrical system are not adjacent to each other. Designating an inter-discharge portion distance between non-adjacent discharge portions as B₁, the following relationship is established between the inter-discharge portion distance B between the adjacent discharge portions: B₁ > B. Thus, focusing on an interval between the discharge portions connected to the power supply portion via the identical electrical system, the interval is wider in the present invention than in the conventional one (see Fig. 8).
However, because discharge portions connected to the power supply portion via different electrical systems are less prone to interfere with each other, with the present invention, it is possible to set the inter-discharge portion distance B of the adjacent discharge portions relative to the interelectrode distance A to be narrower than that in the conventional one (see Fig. 8). Specifically, conventionally, it has been necessary for the inter-discharge portion distance B to be at least twice as great as the interelectrode distance A. On the other hand, in the present invention, the distance B at least 1.5 times as great as the distance A will suffice. Thus, the inter-discharge portion distance B can drastically be shortened.

Hence, with the plasma processing apparatus of the present invention, in consideration of an increase in a filling rate of the discharge portions inside the reaction chamber (chamber), or a reduction in size of the entire apparatus, it is preferable that the interelectrode distance A between the first electrode and the second electrode in each discharge portion and the inter-discharge portion distance B between the second electrode of one discharge portion and the first electrode of other discharge portion adjacent to the one discharge portion satisfies the relationship of B/A ≥ 1.5.
It is to be noted that, in the present invention, the inter-discharge portion distance B between the discharge portions adjacent to each other being less than 1.5 times as great as the interelectrode distance A is not preferable, because plasma discharges of respective discharge portions connected to the power supply portion via different electrical systems interfere with each other.

With the plasma processing apparatus of the present invention, in addition to employing one of the connection modes (a) and (b) between each first electrode and the power supply portion, it is preferable that: (c) the first electrode of one discharge portion and the first electrode of other discharge portion non-adjacent to the one discharge portion are connected to an identical high frequency generator via an identical amplifier with an identical electrical system.
With the connection mode (c), the power supply portion can be shared by a plurality of the discharge portions being non-adjacent to one another, whereby a simplified apparatus structure can be achieved.

In the present invention, in order to achieve more uniform plasma discharges occurring over the entire apparatus, so as to carry out more uniform deposition or etching at the discharge portions, and to facilitate apparatus designing, the plasma processing apparatus may be structured as follows.
(1) The power supply portion supplies synchronized high frequency power to the first electrode of one discharge portion and to the first electrode of other discharge portion adjacent to the one discharge portion. Here, the "synchronized high frequency power" means the high frequency power of the identical waveform.
(2) One discharge portion out of all the discharge portions and other discharge portion non-adjacent to the one discharge portion are identical to each other in a shape, a size and a power supply position of their respective first electrodes, and are identical to each other in the shape, the size and a ground position of their respective second electrodes.

(3) One discharge portion out of all the discharge portions and other discharge portion adjacent to the one discharge portion are different in the power supply position of their respective first electrodes.
(4) The first electrodes and the second electrodes are each of a parallel plate type electrode whose planer shape is rectangular, and one discharge portion out of all the discharge portions and other discharge portion adjacent to the one discharge portion have power supply positions in their respective first electrodes set at center portions of respective electrode end faces being opposite to each other by 180 degrees.

Employing the structure of (1), it becomes possible to suppress a plasma discharge fluctuation phenomenon that is caused by two adjacent discharge portions respectively supplied with high frequency power of different waveforms. Here, the "plasma discharge fluctuation phenomenon" means a phenomenon in which the waveform suffers from deformation and resonance due to interference between each high frequency power, whereby power supply of desired waveform is hindered. It is to be noted that, when using two or more power supply portions, in order to prevent the fluctuation phenomenon, it is necessary to carry out adjustment for causing the power supply portions to generate high frequency power of the same waveform, for example, by using a variable delay circuit.

Employing the structure of (2), a plurality of the first electrodes connected with the identical electrical system are supplied with power under substantially the same conditions. Therefore, the first electrodes are supplied with equally distributed power from the identical power supply portion. Further, in the case where the first electrodes and the second electrodes of the parallel plate type are supported by the support portions in a horizontal manner, a plurality of the first electrodes connected with the identical electrical system are identical to one another in their shape and their size. Therefore, deflection amounts caused by their respective self weights are also identical. Thus, the relationship between the interelectrode distance A and the inter-discharge portion distance B will not be affected.

Employing the structure of (3), the power supply position of one discharge portion and the power supply position of other discharge portion adjacent to the one discharge portion will not align on the same line. Therefore, flanges for fixing power supply cables to the chamber can be attached without being arranged close to one another, whereby the apparatus designing is facilitated. Further, the power supply cables can be arranged while keeping a certain distance among themselves. This makes it possible to suppress electrical and thermal interference among them. This structure may specifically be realized by employing the structure (4).
It goes without saying that, in the present invention, it is preferable to combine the structures (1) to (4).

In the following, with reference to the drawings, specific embodiments of a plasma processing apparatus of the present invention will be described.

### (First Embodiment)

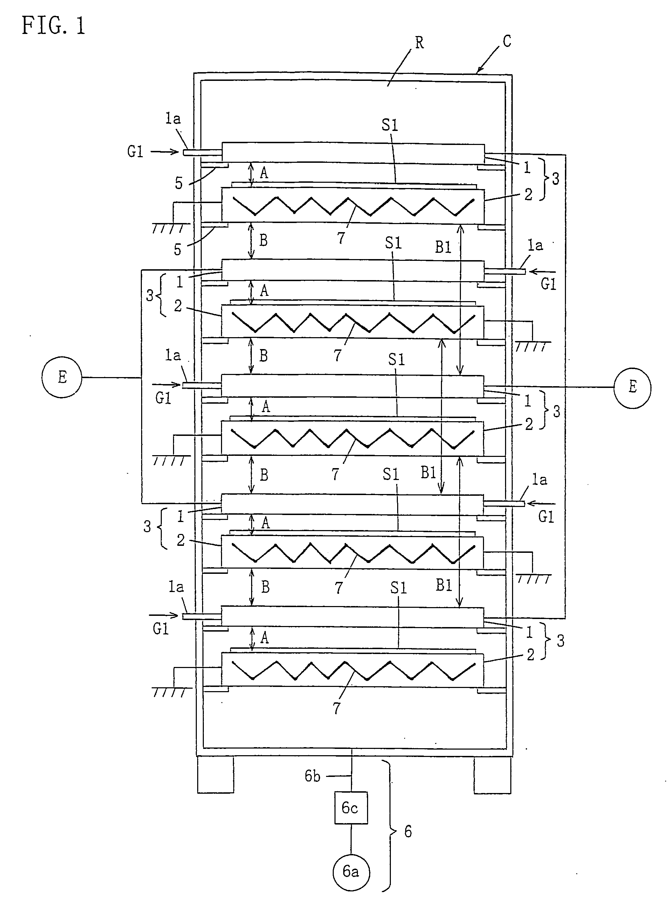

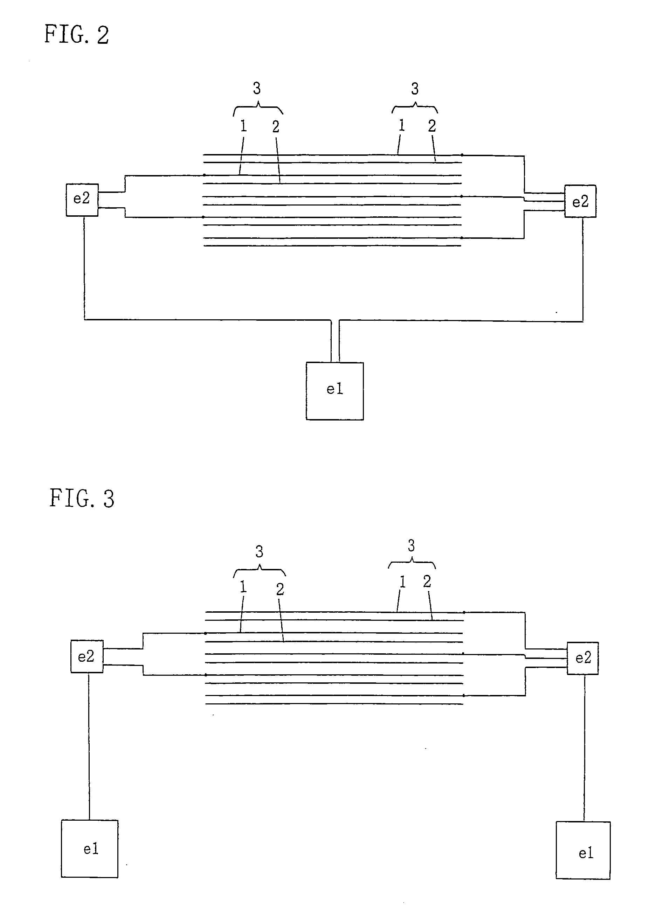

Fig. 1 is a schematic configuration diagram of a first embodiment of the plasma processing apparatus of the present invention. Fig. 2 is an explanatory diagram showing a first power supply connection mode in the first embodiment. Fig. 3 is an explanatory diagram showing a second power supply connection mode in the first embodiment.
The plasma processing apparatus of the first embodiment is a deposition purpose plasma processing apparatus of a top-bottom parallel type that deposits a desired film on a surface of each substrate S1 being a processing target object, and plasma processing apparatus includes a reaction chamber R, gas inlet portions 1a that introduce a reactant gas G 1 into the reaction chamber R, an exhaust portion 6 that exhausts the reactant gas G1 from the reaction chamber R, at least three discharge portions 3 each made up of a pair of a first electrode 1 and a second electrode 2 that are disposed to oppose to each other inside the reaction chamber R to cause a plasma discharge in the reactant gas G1, support portions 5 that support and parallel the pairs of the first electrode 1 and the second electrode 2 in a horizontal manner or a vertical manner, and a power supply portion E that supplies power to all the discharge portions.

In the plasma processing apparatus, the power supply portion E includes a high frequency generator e1 and an amplifier e2 that amplifies high frequency power from the high frequency generator e 1 to supply the first electrode 1 with amplified high frequency power. A first electrode 1 constituting one discharge portion 3 out of all the discharge portions 3 and other first electrode 1 constituting other discharge portion 3 adjacent to the one discharge portion 3 are connected to the identical high frequency generator e1 via separate amplifiers e2 as shown in Fig. 2, or connected to different high frequency generators e1 via the amplifiers e2 as shown in Fig. 3, while the plurality of second electrodes 2 are each grounded.
While the power supply portion E is illustrated two in number in Fig. 1, it does not mean that separate high frequency generators are always employed. Further, while Figs. 1 to 3 exemplarily show the plasma processing apparatus in which five discharge portions 3 are disposed in the vertical order, the number of the discharge portions 3 may be two to four, or may be six or more.
In the following, in the embodiments of the present invention, the first electrode 1 is referred to as a cathode electrode 1, and the second electrode 2 is referred to as an anode electrode 2.

The reaction chamber R is structured with a sealable chamber C that accommodates a plurality of the discharge portions 3.
The chamber C is box-shaped. To the chamber C, the exhaust portion 6 is connected, and to a chamber inner wall surface, the support portions 5 that support a plurality of the cathode electrodes 1 and a plurality of the anode electrodes 2 are formed.
The exhaust portion 6 includes a vacuum pump 6a, an exhaust pipe 6b connecting the vacuum pump 6a and the reaction chamber R, and a vacuum controller 6c disposed between the reaction chamber R and the vacuum pump 6a in the exhaust pipe 6b.

The support portions 5 are each a support piece that projects by a prescribed dimension from the inner wall surface of the chamber C in a horizontal direction, and are provided at a plurality of vertical places of the inner wall surface at prescribed intervals, so as to support the cathode electrodes 1 and the anode electrodes 2 each being flat plate-shaped to be parallel to one another and in the horizontal manner. In the first embodiment, the support portions 5 are provided ten in number, so as to support four corners, or nearby portions thereof, of bottom surfaces of five pairs of the cathode and anode electrodes 1 and 2.

Here, the support pieces of the support portions 5 are disposed each at a height position whereby an inter-discharge portion distance B between the anode electrode 2 of one discharge portion 3 and the cathode electrode 1 of other discharge portion 3 adjacent to the one discharge portion 3 becomes at least 1.5 times as great as an interelectrode distance A between the cathode electrode 1 and the anode electrode 2 in each of the discharge portions 3. For example, the interelectrode distance A is set to 2 to 30 mm, and the inter-discharge portion distance B is set to 3 to 45 mm or more. An in-plane accuracy of the interelectrode distance A is preferably within several percents, and particularly preferably equal to or smaller than 1 percent.

Each of the anode electrodes 2 includes therein a heater 7, and has the substrate S 1 disposed on its top surface, to heat the substrate S1 when forming a film under plasma discharge conditions. It is to be noted that, while each substrate S1 is generally a silicon substrate, a glass substrate and the like, the present invention is not particularly limited thereto.
Further, the anode electrodes 2 are made of an electrically conductive and heat resistant material such as stainless steel, aluminum alloy, carbon or the like.
Dimensions of each of the anode electrodes 2 are set to appropriate values, so as to conform to dimensions of the substrate S 1 for forming a thin film. For example, the dimensions of each of the anode electrodes 2 are designed to be 1000 to 1500 mm × 600 to 1000 mm, for the substrate S1 measuring 900 to 1200 mm × 400 to 900 mm.
The heater 7 included in each of the anode electrodes 2 is to perform controlled heating of the anode electrodes 2 in a range of a room temperature to 300°C. For example, an element made up of an aluminum alloy including therein an encapsulated heating apparatus such as a sheath heater and an encapsulated temperature sensor such as a thermocouple can be employed as the heater 7.

The cathode electrodes 1 are prepared from the stainless steel, the aluminum alloy or the like. Dimensions of each of the cathode electrodes 1 are set to appropriate values, so as to conform to the dimensions of the substrate S 1 on which the deposition is carried out. The cathode electrodes 1 can each be designed to have the same dimensions (a plane size and a thickness) as those of the anode electrodes 2.
An interior of each of the cathode electrodes 1 is cavity. A plasma discharge surface of each of the cathode electrodes 1 that opposes to its paired one of the anode electrodes 2 is provided with a multitude of through holes by a perforation working. This perforation working is desirably carried out so as to form circular holes each having a diameter of 0.1 mm to 2 mm with a several mm to several cm pitch.
To one end surface of each of the cathode electrodes 1, a gas inlet pipe as the gas inlet portion 1a is connected. A not-shown gas supply source and the gas inlet portion 1a are connected to each other by a connection pipe. The reactant gas G1 is supplied from the gas supply source into inside each cathode electrode 2, and is sprayed from the multitude of through holes toward the surface of the substrate S 1. It is noted that, as the raw gas, for example, an SiH₄ (monosilane) gas diluted with H₂ is used.

The power supply portion E is a plasma excitation power supply. The power supply portion E supplies the cathode electrodes 1 with power of, for example, 10 W to 100 kW at an AC frequency of 1.00 MHz to 60 MHz, specifically, with power of 10 W to 10 kW at 13.56 MHz to 60 MHz.

In the plasma processing apparatus according to the first embodiment, in a power supply connection mode shown in Fig. 2, respective first electrodes 1 of the first, the third and the fifth discharge portions 3 out of all the discharge portions 3, each counted from the bottom (hereinafter, also referred to as an odd-number group), and respective first electrodes 1 of the second and the fourth discharge portions 3 (hereinafter, also referred to as an even-number group) are respectively connected via separate amplifiers e2 to the identical high frequency generator e1. In this case, the cathode electrodes 1 respectively belonging to two adjacent discharge portions 3 are connected to the identical high frequency generator e 1 via the separate amplifiers e2. That is, the cathode electrodes 1 respectively belonging to the two adjacent discharge portions 3 are connected via different electrical systems to the high frequency generator e1.
Further, in a power supply connection mode shown in Fig. 3, respective first electrodes 1 belonging to the odd-number group out of all the discharge portions 3, and respective first electrodes 1 belonging to the discharge portions 3 of the even-number group are respectively connected via the amplifiers e2 to the different high frequency generators e1. In this case, the cathode electrodes 1 of two adjacent discharge portions 3 are connected via the separate amplifiers e2 to the separate high frequency generators e1. That is, the cathode electrodes 1 respectively belonging to the two adjacent discharge portions 3 are connected via different electrical systems to the high frequency generators e1.

Thus, in either of the power supply connection modes shown in Figs. 2 and 3, the cathode electrodes 1 respectively belonging to the two adjacent discharge portions 3 are connected to the high frequency generator(s) e1 via the different electrical systems. Further, an inter-discharge portion distance B1 between, e.g., the fifth and third discharge portions 3 belonging to the odd-number group and that between the third and first discharge portions 3, and the inter-discharge portion distance B1 between, e.g., the fourth and second discharge portions 3 belonging to the even-number group, are both wider than the inter-discharge portion distance B between the two adjacent discharge portions 3. This makes the plasma discharges occurring at the two adjacent discharge portions 3 less prone to interfere with each other.
Hence, the cathode electrodes 1 belonging to the odd-number group are supplied with the power being equally distributed from the amplifiers e2, and the cathode electrodes 1 belonging to the even-number group are supplied with the power being equally distributed from the amplifiers e2, whereby equivalent plasma processing can be carried out at the discharge portions 3. In addition thereto, it becomes possible to narrow the inter-discharge portion distance B than it has conventionally been.

Meanwhile, in consideration of suppressing the plasma discharge fluctuation phenomenon at the discharge portions 3, it is preferable that the two adjacent discharge portions 3 are supplied with synchronized high frequency power.
In the power supply connection mode shown in Fig. 2, the high frequency power generated by the identical high frequency generator e 1 is supplied to both the odd-number group and the even-number group, and, therefore, a waveform of the high frequency power supplied to each of the two adjacent discharge portion 3 is basically identical. Thus, there is no necessity of adjusting the waveform. On the other hand, in the power supply connection mode shown in Fig. 3, the different high frequency generators e 1 generate the high frequency power and respectively supply the power to the odd-number group and the even-number group. Therefore, there arises necessity of adjusting the waveforms for unifying the waveforms of the high frequency power supplied to the two adjacent discharge portions 3.
Accordingly, it is preferable to employ the power supply connection mode shown in Fig. 2, in consideration of capability of supplying the two adjacent discharge portions 3 with the high frequency power of the synchronized identical waveform, and of reducing the number of the high frequency generators e 1.

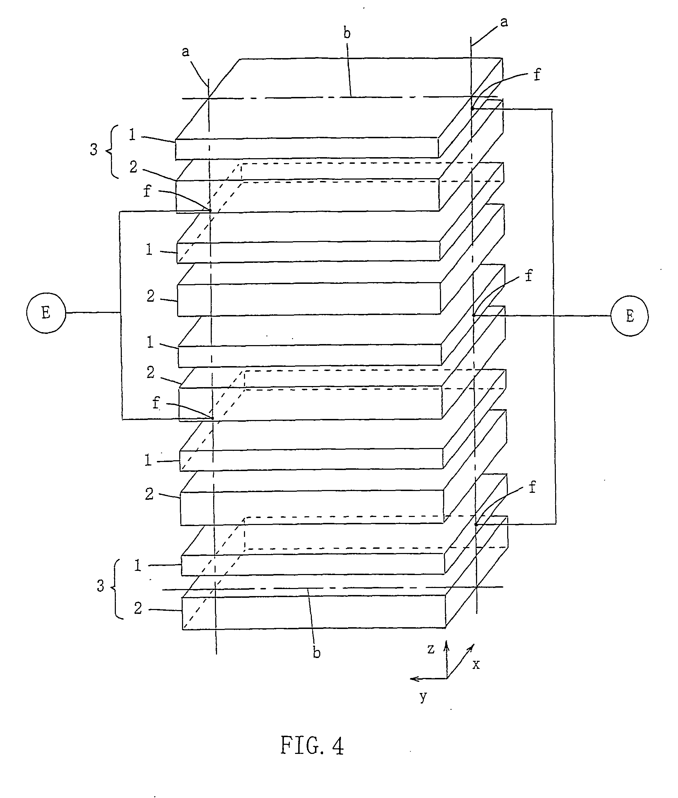

Further, in the plasma processing apparatus of the first embodiment, as shown in Fig. 4, as to a plurality of the discharge portions 3 connected with the identical electrical system, a plurality of the cathode electrodes 1 are identical in the shape and the size; a positional relationship of the power supply position relative to every one of the cathode electrodes 1 is identical; a plurality of anode electrodes 2 are identical in the shape and the size; and a positional relationship of the ground position relative to every one of the anode electrodes 2 is identical. Further, in the first embodiment, the shape and the size (except for the thickness) of the cathode electrodes 1 and the anode electrodes 2 are identical.

This is described in more detail. As shown in Figs. 1 and 4, as to the five discharge portions 3 arranged in the vertical order, each cathode electrode 1 and each anode electrode 2 both being the parallel plate type are disposed so as to be horizontally opposed to each other. A center position in terms of an X direction (depth direction) and a Z direction (top-bottom direction) at a right end face of each cathode electrode 1 belonging to the odd-number group is set to be a power supply position f, and the center position in terms of the X direction and the Z direction at a left end face of each cathode electrode 1 belonging to the even-number group is set to be a power supply position f. A not-shown power supply cable is connected to each power supply position of the corresponding cathode electrode 1. It is to be noted that, in Fig. 4, lines a represent center lines that pass through the center positions in the X direction respectively at the right and the left end faces of the cathode electrodes 1 and the anode electrodes 2, and lines b represent center lines that pass through the center positions in the X direction respectively at a top surface of the topmost cathode electrode 1 and at a bottom surface of the bottommost anode electrode 2.

It is to be noted that, in the odd-number group, though it is preferable that the ground positions of the anode electrodes 2 are identical relative to one another and arranged on one of the lines a, the ground positions may be the one on the right end face side similarly to the cathode electrodes 1, or may be the other one on the opposite left end face side. In a similar manner, in the even-number group, though it is preferable that the ground positions of the anode electrodes 2 are identical relative to one another and arranged on one of the lines a, the ground positions may be the one on the left end face side similarly to the cathode electrodes 1, or may be the other one on the opposite right end face side.
Further, in Figs. 2 and 3, the exemplary case has been shown, in which the odd-number group and the even-number group are connected to the identical high frequency generator e 1 or the separate high frequency generators e1 via the single amplifier e2, the present invention is not limited thereto. For example, in a case of a plasma processing apparatus where the odd-number group is constituted by the first, third, fifth, and seventh discharge portions, and the even-number group is constituted by the second, fourth, sixth and eighth discharge portions, the odd-number group and the even-number group are connected to the identical high frequency generator e 1 or the separate high frequency generators e 1 respectively via two or more amplifiers e2, so as to reduce a load per amplifier.

In the deposition purpose plasma processing apparatus structured in this manner, by introducing the reactant gas G 1 being a film material into a gap between each cathode electrode 1 and each anode electrode 2 at a prescribed flow rate and a prescribed pressure, and applying the high frequency power to each cathode electrode 1 and each anode electrode 2, it becomes possible to produce a glow discharge region (a plasma discharge region) between each cathode electrode 1 and each anode electrode 2, so as to form an amorphous film or a crystalline film on each substrate S1. For example, by using SiH₄ gas diluted with H₂ as the raw gas, a silicon thin film having a thickness of 300 nm can be deposited within a thickness distribution of ± 10%.

Here, in the three cathode electrodes 1 belonging to the odd-number group and connected via the identical electrical system, the power supply position f for each cathode electrode 1 is identical to every cathode electrode 1, and in the two cathode electrodes 1 belonging to the even-number group connected via the identical electrical system, the power supply position f for each cathode electrode 1 is identical to every cathode electrode 1. Therefore, the plasma discharges occurring at the two adjacent discharge portions little interfere with each other. As a result, the cathode electrodes 1 connected via the same electrical system are supplied with more equally distributed power from the power supply portion E. Further, because the cathode electrodes 1 respectively belonging to the odd-number group and the even-number group are identical in the shape and the size, their respective self weights yield equivalent deflection amounts. Still further, because the anode electrodes 2 belonging to the odd-number group and the even-number group are identical in the shape and the size, their respective self weights yield equivalent deflection amounts. Thus, there exist little variations in the interelectrode distance A, giving no effect to the relationship between the interelectrode distance A and the inter-discharge portion distance B.
Accordingly, despite a presence of a plurality of the plasma discharges in the single chamber, they do not interfere with one another. Thus, a deposition step in a manufacturing process of semiconductor devices can be carried out efficiently with a high accuracy by the plasma processing apparatus of the first embodiment.

### (Second Embodiment)

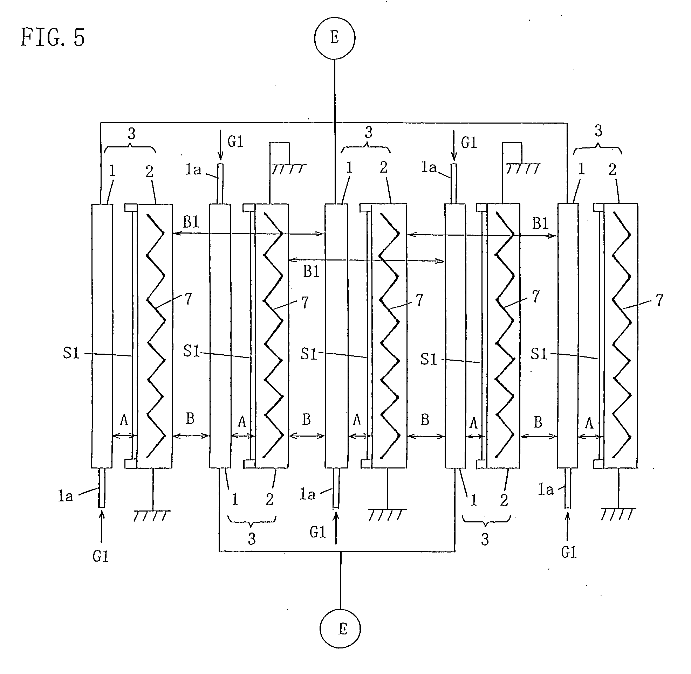

Fig. 5 is a schematic configuration diagram showing a second embodiment of the plasma processing apparatus of the present invention. In Fig. 5, constituents that are identical to those shown in Figs. 1 to 4 are denoted by identical reference characters.
The plasma processing apparatus of the second embodiment is also the deposition purpose plasma processing apparatus, and a major difference from the first embodiment (of the top-bottom parallel type) lies in that the plasma processing apparatus of the second embodiment is of a sideways parallel type. That is, a structure of the plasma processing apparatus of the second embodiment corresponds to that of the plasma processing apparatus of the first embodiment substantially lying on its side, the structure of the plasma processing apparatus of the first embodiment having been described with reference to Fig. 1.
While the chamber C, the support portions 5 and the exhaust portion 6 shown in Fig. 1 are omitted from Fig. 5, the plasma processing apparatus of the second embodiment also includes these constituents. However, according to the second embodiment, the support portions are configured to support the cathode electrodes 1 and the anode electrodes 2 in a vertical manner. A plurality of the support pieces structuring the support portions project in the top-bottom direction from a top inner wall surface and a bottom inner wall surface of the chamber, to thereby clamp the electrodes from opposite sides. Further, on a substrate placement plane of each anode electrode 2, protrusion portions that hold each substrate S 1 are formed. It is to be noted that each substrate S 1 may be held by the support pieces that support each anode electrode 2.

As in the first embodiment, in the plasma processing apparatus of the second embodiment also, by introducing the reactant gas G1 being the film material into the gap between each cathode electrode 1 and each anode electrode 2 at a prescribed flow rate and a prescribed pressure, and applying the high frequency power to each cathode electrode 1 and each anode electrode 2, it becomes possible to produce the glow discharge region (the plasma discharge region) between each cathode electrode 1 and each anode electrode 2, so as to form the amorphous film or the crystalline film on each substrate S 1.

Here, as in the first embodiment, the cathode electrodes 1 connected via the same electrical system are supplied with more equally distributed power from the power supply portion E, and despite the presence of a plurality of the plasma discharges in the single chamber, they do not interfere with one another.
Further, because the plasma processing apparatus of the second embodiment is of the sideways parallel type in which the cathode electrodes 1 and the anode electrodes 2 are vertically supported, the effect of the deflection at each electrode as seen in the first embodiment is small. Thus, there exist little variations in each interelectrode distance A and each inter-discharge portion distance B.
Owing to these facts, with the plasma processing apparatus of the second embodiment also, the deposition step in the manufacturing process of the semiconductor devices can be carried out efficiently with the high accuracy.

### (Third Embodiment)

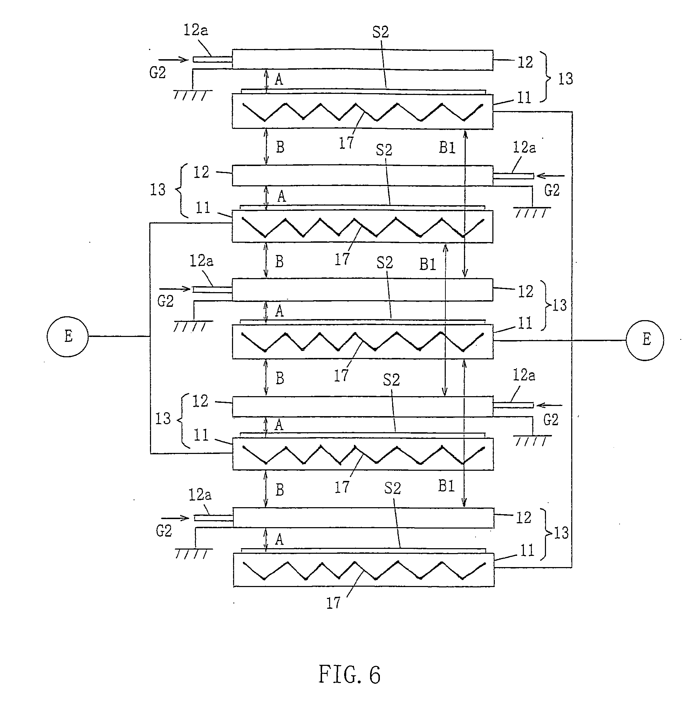

Fig. 6 is a schematic configuration diagram showing a third embodiment of the plasma processing apparatus of the present invention. In Fig. 6, constituents that are identical to those shown in Fig. 1 are denoted by the identical reference characters.
The plasma processing apparatus of the third embodiment is an etching purpose plasma processing apparatus of the top-bottom parallel type. As in the first embodiment, the plasma processing apparatus includes a plurality of discharge portions 13 each made up of a pair of a cathode electrode 11 and an anode electrode 12, a not-shown chamber, not-shown support portions and a not-shown exhaust portion.

A major difference of the third embodiment from the first embodiment lies in that, in each discharge portion 13, the cathode electrode 11 and the anode electrode 12 are inversely disposed in terms of their relative top-bottom positions, each substrate S2 being placed on each cathode electrode 11 connected to the power supply portion E, and each grounded anode electrode 12 being disposed above each substrate S2.
In this case, similarly to the cathode electrode 1 of the first embodiment, each anode electrode 12 of the third embodiment includes a gas inlet portion 12a for introducing a reactant gas G2 inside, and provided with multitude of through holes at its bottom surface for the reactant gas G2 to be sprayed.
Further, similarly to each anode electrode 2 of the first embodiment, each cathode electrode 11 of the third embodiment includes therein a heater 17.

It is to be noted that, as in the first embodiment, in the third embodiment also, the inter-discharge portion distance B between the cathode electrode 11 of one discharge portion 13 and the anode electrode 12 of other discharge portion 13 adjacent to the one discharge portion 13 is set to at least 1.5 times as great as the interelectrode distance A between the cathode electrode 11 and the anode electrode 12 in each of the discharge portion 13. For example, the interelectrode distance A is set to 2 to 30 mm, and the inter-discharge portion distance B is set to 3 to 45 mm or more. An in-plane accuracy of the interelectrode distance A is preferably within several percents, and particularly preferably equal to or smaller than 1 percent.

With the plasma processing apparatus of the third embodiment, for example, by filling the gap between each cathode electrode 11 and each anode electrode 12 with the reactant gas G2 being an etching gas obtained by diluting a fluorinated gas with an inert gas such as argon at a prescribed flow rate and a prescribed pressure, and applying high frequency power to each cathode electrode 11 and each anode electrode 12, it becomes possible to produce the glow discharge region (the plasma discharge region) between the cathode electrode 11 and the anode electrode 12, and to efficiently etch each substrate S2 (for example, a silicon substrate) at a rate equal to or greater than 10 nm/s.

Here, as in the first embodiment, the cathode electrodes 1 connected via the same electrical system are supplied with more equally distributed power from the power supply portion E, and despite a presence of a plurality of the plasma discharges in the single chamber, they do not interfere with one another. Further, because the cathode electrodes 1 respectively belonging to the odd-number group and the even-number group are identical in the shape and the size, their respective self weights yield equivalent deflection amounts. Still further, because the anode electrodes 2 belonging to the odd-number group and the even-number group are identical in the shape and the size, their respective self weights yield equivalent deflection amounts. Thus, there exist little variations in the interelectrode distance A, giving no effect to the relationship between the interelectrode distance A and the inter-discharge portion distance B.
Owing to these facts, with the plasma processing apparatus of the third embodiment, an etching step in the manufacturing process of the semiconductor devices can be carried out efficiently with the high accuracy.

### (Fourth Embodiment)

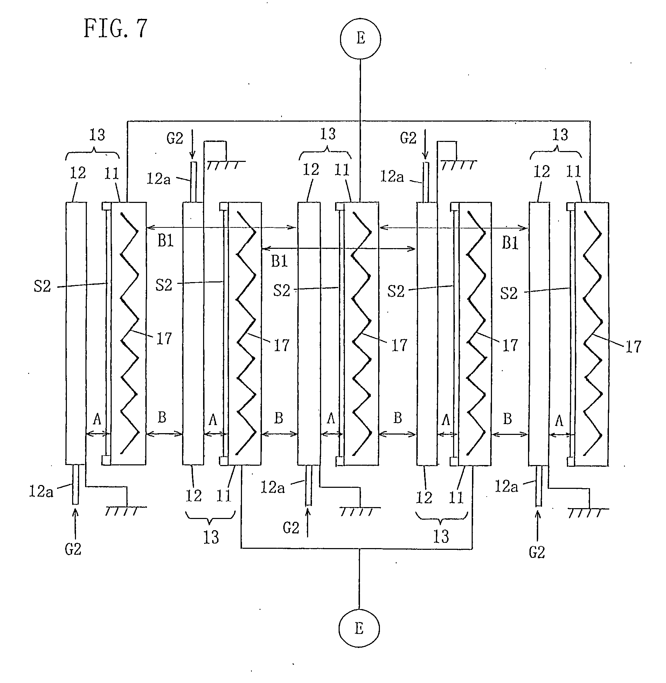

Fig. 7 is a schematic configuration diagram showing a fourth embodiment of the plasma processing apparatus of the present invention. In Fig. 7, constituents that are identical to those shown in Fig. 6 are denoted by the identical reference characters.
The plasma processing apparatus of the fourth embodiment is also the etching purpose plasma processing apparatus, and a major difference from the third embodiment (of the top-bottom parallel type) lies in that the plasma processing apparatus of the fourth embodiment is of the sideways parallel type. That is, a structure of the plasma processing apparatus of the fourth embodiment corresponds to that of the plasma processing apparatus of the third embodiment substantially lying on its side, the structure of the plasma processing apparatus of the third embodiment having been given with reference to Fig. 6.
As in the third embodiment, the plasma processing apparatus of the fourth embodiment also includes the discharge portions 13 each made up of the cathode electrode 11 and the anode electrode 12, and the chamber, the support portions and the exhaust portion, each not shown. It is to be noted that, in the fourth embodiment, the support portions are similarly structured as those of the second embodiment.

With the plasma processing apparatus of the fourth embodiment also, similarly to the third embodiment, for example, by introducing into the gap between each cathode electrode 11 and each anode electrode 12 the reactant gas G2 being an etching gas obtained by diluting a fluorinated gas with an inert gas such as argon at a prescribed flow rate and a prescribed pressure, and applying high frequency power to each cathode electrode 11 and each anode electrode 12, it becomes possible to produce the glow discharge region (the plasma discharge region) between the cathode electrode 11 and the anode electrode 12, and to efficiently etch each substrate S2 (for example, a silicon substrate) at a rate equal to or greater than 10 nm/s.

Here, as in the third embodiment, the cathode electrodes 1 connected via the same electrical system are supplied with more equally distributed power from the power supply portion E, and despite a presence of a plurality of the plasma discharges in the single chamber, they do not interfere with one another.
Further, because the plasma processing apparatus of the fourth embodiment is of the sideways parallel type in which the cathode electrodes 11 and the anode electrodes 12 are vertically supported, the effect of the deflection at each electrode as seen in the third embodiment is small. Thus, there exist little variations in each interelectrode distance A and each inter-discharge portion distance B.
Owing to these facts, with the plasma processing apparatus of the fourth embodiment also, the etching step in the manufacturing process of the semiconductor devices can be carried out efficiently with the high accuracy.

### (Other Embodiment)

In the first to fourth embodiments described above, the description has been given of the exemplary cases in which the cathode electrodes belonging to the odd-number group and the cathode electrodes belonging to the even-number group are formed to be identical in the shape and the size, and the anode electrodes belonging to the odd-number group and the anode electrodes belonging to the even-number group are formed to be identical in the shape and the size. However, the cathode electrodes belonging to the odd-number group and the cathode electrodes belonging to the even-number group may be formed to be different in the shape and the size, and the anode electrodes belonging to the odd-number group and the anode electrodes belonging to the even-number group may be formed to be different in the shape and the size. That is, because plasma discharges respectively occurring at two adjacent discharge portions respectively connected via different electrical systems are less prone to interfere with each other, the shape and the size of the cathode electrodes and the anode electrodes can be modified to be different between the odd-number group and the even-number group.
This makes it possible to arbitrarily adjust discharge conditions for each of the odd-number group and the even-number group. With separate gas supply systems, totally different deposition processes can simultaneously be carried out inside the identical chamber.

### INDUSTRIAL APPLICABILITY

The plasma processing apparatus of the present invention is applicable to, for example, a CVD apparatus used in the deposition step in the manufacturing process of various semiconductor devices such as a solar battery, a TFT, a photosensitive element, or an RIE apparatus used in the etching step.

### DESCRIPTION OF REFERENCE CHARACTERS

1, 11 first electrode (cathode electrode)
1a, 12a gas inlet portion
2, 12 second electrode (anode electrode)
3, 13 discharge portion
5 support portion (support piece)
6 exhaust portion
7, 17 heater
A interelectrode distance
B inter-discharge portion distance (between discharge portions adjacent to each other)
B 1 inter-discharge portion distance (between discharge portions not adjacent to each other)
C chamber
E power supply portion
e1 high frequency generator
e2 amplifier
G1, G2 reactant gas
R reaction chamber
S1, S2 substrate (processing target object)

## Claims

1. A plasma processing apparatus, comprising:
a reaction chamber;
a gas inlet portion that introduces a reactant gas into the reaction chamber;
an exhaust portion that exhausts the reactant gas from said reaction chamber;
at least three discharge portions respectively made up of first electrode and second electrode pairs, a first electrode and a second electrode constituting each one of the first electrode and second electrode pairs being disposed to oppose to each other inside said reaction chamber, so as to cause a plasma discharge in the reactant gas;
a support portion that supports and parallels the first electrode and second electrode pairs in one of a horizontal manner and a vertical manner; and
a power supply portion that supplies power to all of said discharge portions, wherein
said power supply portion includes a high frequency generator and an amplifier that amplifies high frequency power from the high frequency generator to be supplied to the first electrodes, and
a first electrode of one discharge portion out of said discharge portions and a first electrode of other discharge portion out of said discharge portions being adjacent to the one discharge portion are connected to an identical one of the high frequency generator respectively via separate ones of the amplifier, or respectively connected to separate ones of the high frequency generator via the amplifier, and the second electrodes of respective discharge portions are grounded.

2. The plasma processing apparatus according to claim 1, wherein
said power supply portion supplies the first electrode of the one discharge portion out of said discharge portions and the first electrode of the other discharge portion out of said discharge portions being adjacent to the one discharge portion with the high frequency power being synchronized.

3. The plasma processing apparatus according to claim 1, wherein
the first electrode of the one discharge portion out of said discharge portions and a first electrode of other discharge portion out of said discharge portions being non-adjacent to the one discharge portion are connected with an identical electrical system via the identical one of the amplifier to an identical one of the high frequency generator.

4. The plasma processing apparatus according to claim 1, wherein
the one discharge portion out of said discharge portions and other discharge portion out of said discharge portions being non-adjacent to the one discharge portion are identical to each other in a shape, a size and a power supply position of their respective first electrodes, and are identical to each other in the shape, the size and a ground position of their respective second electrodes.

5. The plasma processing apparatus according to claim 1, wherein
the one discharge portion out of said discharge portions and the other discharge portion out of said discharge portions being adjacent to the one discharge portion are different from each other in a power supply position of their respective first electrodes.

6. The plasma processing apparatus according to claim 1, wherein
said first electrodes and said second electrodes are each a parallel plate type electrode whose planar shape is rectangular, and
the one discharge portion out of said discharge portions and the other discharge portion out of said discharge portions being adjacent to the one discharge portion have power supply positions in their respective first electrodes set at center portions of respective electrode end faces being opposite to each other by 180 degrees.

7. The plasma processing apparatus according to claim 1, wherein
an interelectrode distance A between the first electrode and the second electrode in each of said discharge portions and an inter-discharge portion distance B between the second electrode of the one discharge portion out of said discharge portions and the second electrode of the other discharge portion out of said discharge portions being adjacent to the one discharge portion satisfy a relationship of B/A ≥ 1.5.
